(19) Europäisches Patentamt / European Patent Office / Office européen des brevets

(11) **EP 2 751 917 B1**

(12) **FASCICULE DE BREVET EUROPEEN**

(45) Date de publication et mention de la délivrance du brevet:
**10.10.2018 Bulletin 2018/41**

(21) Numéro de dépôt: **12756683.4**

(22) Date de dépôt: **30.08.2012**

(51) Int Cl.:
*H02M 1/088* (2006.01)   *H03K 17/0412* (2006.01)

(86) Numéro de dépôt international:
**PCT/EP2012/066917**

(87) Numéro de publication internationale:
**WO 2013/030308 (07.03.2013 Gazette 2013/10)**

(54) **CONVERTISSEUR DE PUISSANCE ÉLEVÉE COMPRENANT DES INTERRUPTEURS DE FAIBLE PUISSANCE ET UN DISPOSITIF DE COMMANDE DES INTERRUPTEURS POUR LA GÉNÉRATION D'UNE IMPULSION AVEC UNE VALEUR DE RÉFÉRENCE ET AU MOINS DEUX VALEURS DE COMMANDE**

LEISTUNGSSTARKER WANDLER MIT NIEDRIGENERGIESCHALTER UND SCHALTSTEUERUNGSVORRICHTUNG ZUR ERZEUGUNG EINES PULSES MIT EINEM REFERENZWERT UND MINDESTENS ZWEI STEUERWERTEN

HIGH-POWER CONVERTER COMPRISING LOW-POWER SWITCHES AND A SWITCH-CONTROL DEVICE FOR GENERATING A PULSE WITH A REFERENCE VALUE AND AT LEAST TWO CONTROL VALUES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.09.2011 FR 1157749**

(43) Date de publication de la demande:
**09.07.2014 Bulletin 2014/28**

(73) Titulaire: **GE Energy Power Conversion Technology Limited**
**Rugby**
**Warwickshire CV21 1BU (GB)**

(72) Inventeur: **PERMUY, Alfred**
**F-92500 Rueil Malmaison (FR)**

(74) Mandataire: **Serjeants LLP**
**Dock**
**75 Exploration Drive**
**Leicester, LE4 5NU (GB)**

(56) Documents cités:
**US-A- 4 370 607     US-A- 5 089 719**
**US-A1- 2010 302 820**

# Description

La présente invention concerne un système de conversion d'une première tension électrique en une deuxième tension électrique, du type comprenant:

- au moins deux bornes d'entrée et deux bornes de sortie,
- des organes de commutation disposés entre les bornes d'entrée et les bornes de sortie et propres à convertir la première tension en la deuxième tension, et
- un dispositif de commande des organes de commutation, le dispositif de commande comportant une cellule de commande d'un organe de commutation respectif et un organe de pilotage et d'alimentation de la cellule de commande, l'organe de pilotage et d'alimentation étant relié à la cellule de commande par une liaison de transmission simultanée d'un signal de commande et d'une énergie électrique.

La présente invention s'applique en particulier au système de conversion présentant une puissance électrique élevée, telle qu'une puissance supérieure à 1MW.

On connaît un convertisseur de tension du type précité. Le convertisseur est un onduleur de tension triphasée comportant deux bornes de tension continue d'entrée et une borne de sortie pour chaque phase de la tension triphasée de sortie. L'onduleur triphasé comporte deux branches de commutation pour chaque phase. Chaque branche de commutation est connectée entre la borne de sortie correspondante et une borne d'entrée respective, et comporte un organe de commutation. Les organes de commutation sont commandés par un dispositif de commande et sont propres à convertir la tension continue d'entrée en la tension alternative de sortie. Les organes de commutation comportent, par exemple, des interrupteurs électroniques commandables.

Le dispositif de commande comporte une cellule de commande d'un organe de commutation, et un organe de pilotage et d'alimentation de cellules de commande respectives. L'organe de pilotage et d'alimentation est relié à la cellule de commande par une liaison de transmission simultanée du signal de commande correspondant et de l'énergie électrique associée. L'énergie est ainsi transférée en même temps que les signaux de commande, ce qui permet d'avoir une seule liaison entre l'organe de pilotage et d'alimentation et les cellules de commande respectives.

Toutefois, le temps d'établissement du courant entre l'organe de pilotage et les cellules de commande est relativement long, et est une fonction croissante du nombre de cellules de commande reliées à l'organe de pilotage et d'alimentation. La commutation des interrupteurs d'un tel convertisseur de tension est donc relativement lente, ce qui limite la fréquence de commutation des interrupteurs du convertisseur.

US 2010/0302820 A1 décrit un système de conversion de tension, comprenant des organes de commutation ainsi qu'un dispositif de commande avec des moyens d'isolation électrique capable de générer une impulsion de contrôle des organes de commutation.

Le but de l'invention est de proposer un système de conversion permettant d'accélérer la commutation des organes de commutation, afin d'augmenter la fréquence de commutation desdits organes de commutation, et également de réduire les éventuels décalages temporels entre les commutations des organes de commutation.

A cet effet, l'invention a pour objet un système de conversion selon la revendication 1, caractérisé en ce que l'organe de pilotage et d'alimentation comprend des moyens de génération d'une impulsion comportant au moins deux intervalles de commande distincts, l'impulsion présentant pendant le deuxième intervalle de commande une valeur sensiblement constante et distincte d'une valeur de référence correspondant à l'absence de commande, la valeur de l'impulsion étant distincte d'un intervalle de commande à l'autre et l'impulsion présentant pendant le premier intervalle de commande une valeur strictement supérieure à celle pendant le deuxième intervalle de commande..

Suivant d'autres aspects avantageux de l'invention, le système de conversion comprend une ou plusieurs des caractéristiques suivantes, prises isolément ou suivant toutes les combinaisons techniquement possibles :

- les intervalles de commande d'une même impulsion sont successifs l'un de l'autre,
- le système comprend au moins un groupe d'organes de commutation connectés en série, le ou chaque groupe étant connecté entre une borne de sortie et une borne d'entrée correspondantes, une cellule de commande respective étant associée à chaque organe de commutation, et l'organe de pilotage et d'alimentation est unique pour les cellules de commande des organes de commutation d'un même groupe, et propre à piloter la pluralité de cellules de commande des organes de commutation du groupe,
- le dispositif de commande comporte en outre des moyens d'isolation électrique agencés entre chaque cellule de commande et l'organe de pilotage et d'alimentation,
- les moyens d'isolation électrique comportent, pour chaque groupe d'organes de commutation, une pluralité d'enroulements secondaires, une pluralité de circuits magnétiques et un unique enroulement primaire, chaque enroulement secondaire étant électriquement connecté en entrée d'une cellule de commande respective et enroulé autour d'un circuit magnétique respectif, l'unique enroulement primaire étant enroulé autour de chacun des circuits et électriquement connecté en sortie de l'unique organe de pilotage et d'alimentation,
- l'unique enroulement primaire comporte une seule spire passant au travers de chacun des circuits magnétiques correspondants,

- l'impulsion comporte un premier intervalle de commande et un deuxième intervalle de commande, la valeur de l'impulsion durant le premier intervalle étant au moins deux fois supérieure à celle durant le deuxième intervalle,
- la durée du premier intervalle de commande est comprise entre 50 ns et 200 ns, de préférence égale à 100 ns,
- la valeur U2 de l'impulsion durant le deuxième intervalle vérifie l'équation suivante :

$$U2 = (N \times Uc) / M,$$

où N représente le nombre d'organes de commutation du groupe correspondant, N étant un nombre entier supérieur ou égal à 2,
Uc est la tension en entrée de la cellule de commande correspondante, et
M représente le nombre de spires de l'enroulement secondaire correspondant,

- chaque cellule de commande comprend une première branche et une deuxième branche connectées en parallèle, chaque branche comportant un transistor et une diode connectés en série, le transistor de la deuxième branche étant complémentaire de celui de la première branche, et la diode de la deuxième branche étant connectée en sens inverse par rapport à celle de la première branche, et
- les moyens de génération d'une impulsion comportent une borne de sortie pour la délivrance de l'impulsion, et une première branche et une deuxième branche connectées à la borne de sortie, chaque branche comportant un transistor connecté entre un point de référence et la borne de sortie, une résistance connectée entre le point de référence et un premier potentiel, une diode connectée entre le point de référence et un deuxième potentiel, et un condensateur connecté entre le point de référence et une masse électrique, le transistor de la deuxième branche étant complémentaire de celui de la première branche, et la diode de la deuxième branche étant connectée en sens inverse par rapport à celle de la première branche.

Ces caractéristiques et avantages de l'invention apparaîtront à la lecture de la description qui va suivre, donnée uniquement à titre d'exemple, et faite en référence aux dessins annexés sur lesquels :

- la figure 1 est une représentation schématique d'un système de conversion selon l'invention, comprenant six organes de commutation propres à convertir la tension d'entrée en une tension de sortie,
- la figure 2 est un schéma électrique d'un groupe d'organes de commutation et d'un dispositif de commande des organes de commutation, le dispositif de commande comportant une cellule de commande pour chaque organe de commutation respectif, et un organe de pilotage et d'alimentation des cellules de commande,
- la figure 3 est un schéma électrique de la cellule de commande de la figure 2,
- la figure 4 est un schéma électrique de l'organe de pilotage et d'alimentation de la figure 2, et
- la figure 5 est un ensemble de courbes représentant, d'une part, l'impulsion en tension générée par l'organe de pilotage et d'alimentation à destination des cellules de commande, et d'autre part, le courant circulant dans la liaison entre l'organe de pilotage et les cellules de commande.

L'invention concerne un système 10 de conversion d'une première tension électrique en une deuxième tension électrique comprenant au moins deux bornes d'entrée 12 et au moins deux bornes de sortie 14. Le système de conversion 10 comprend des organes de commutation 16 disposés entre les bornes d'entrée 12 et les bornes de sortie 14, et propres à convertir la première tension en la deuxième tension.

Le système de conversion est propre à permettre la circulation d'une puissance électrique élevée, par exemple supérieure à 1MW.

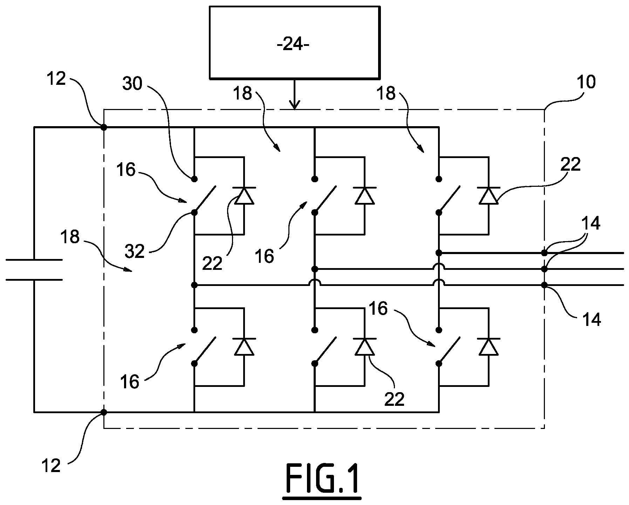

Dans l'exemple de réalisation de la figure 1, le système de conversion 10 est un onduleur de tension propre à convertir une tension continue d'entrée reçue entre les deux bornes d'entrée 12 en une tension alternative de sortie délivrée en chacune des bornes de sortie 14.

L'onduleur de tension 10 comprend deux branches de commutation 18 pour chaque phase de la tension alternative de sortie, chaque branche de commutation 18 étant connectée entre la borne de sortie 14 correspondante et une borne d'entrée 12 respective, et comportant un organe de commutation 16.

L'onduleur de tension comprend une diode 22 connectée en anti-parallèle de chaque organe de commutation 16 et des moyens 24 de commande des organes de commutation.

Dans l'exemple de réalisation de la figure 1, l'onduleur de tension 10 est un onduleur triphasé, et comporte trois bornes de sortie 14 et six branches de commutation 18, à savoir une borne de sortie et deux branches de commutation pour chaque phase de la tension triphasée de sortie.

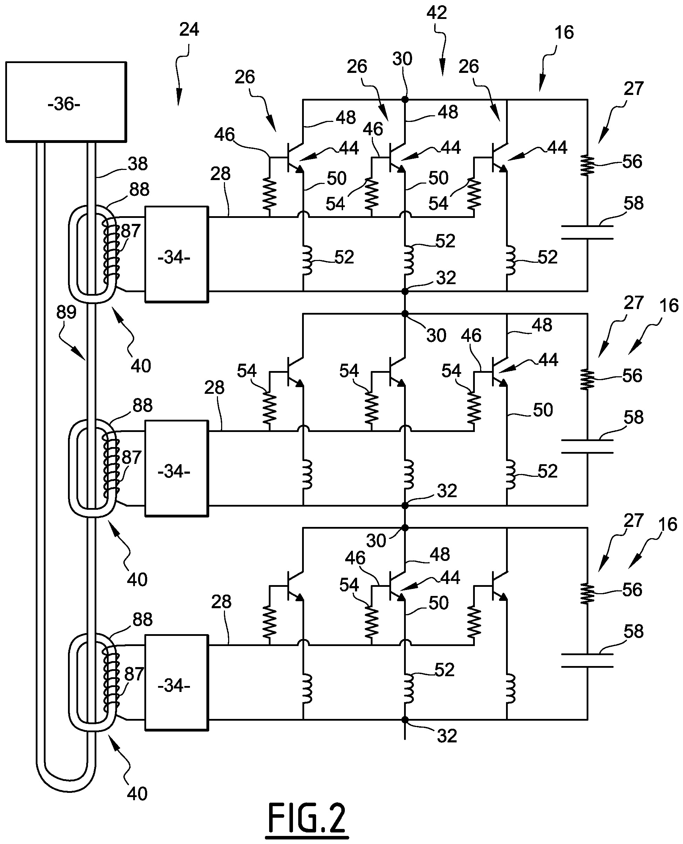

L'organe de commutation 16, visible sur la figure 2, comprend au moins deux bras 26 connectés en parallèle, une borne de commande commune 28, une première borne de conduction commune 30 et une deuxième borne de conduction commune 32.

Dans l'exemple de réalisation de la figure 2, l'organe de commutation 16 comprend trois bras 26 connectés en parallèle.

Dans l'exemple de réalisation des figures 1 et 2, chacun des organes de commutation 16 comprend au moins deux bras 26 connectés en parallèle, de préférence trois bras 26 connectés en parallèle.

En complément, chaque organe de commutation 16 comporte un bras additionnel 27 connecté en parallèle des bras 26.

Le dispositif de commande 24, visible sur la figure 2, comporte une cellule 34 de commande de chaque organe de commutation 16 respectif et un organe 36 de pilotage et d'alimentation des cellules de commande 34, l'organe de pilotage et d'alimentation 36 étant relié à la ou chaque cellule de commande 34 par une liaison 38 de transmission simultanée d'un signal de commande et d'une énergie électrique.

En complément, le dispositif de commande 24 comporte des moyens d'isolation électrique 40 agencés entre chaque cellule de commande 34 et l'organe de pilotage et d'alimentation 36.

Dans l'exemple de réalisation de la figure 2, un groupe 42 d'organes de commutation 16 connectés en série comprend trois organes de commutation 16, le groupe 42 étant connecté entre une borne de sortie 14 et une borne d'entrée 12 correspondante. Une cellule de commande 34 respective est associée à chaque organe de commutation 16, et l'organe de pilotage et d'alimentation 36 est unique pour les trois cellules de commande 34 des organes de commutation du groupe 42.

Chaque bras 26 est connecté entre les première et deuxième bornes de conduction commune 30, 32, et comporte un interrupteur électronique 44 commandable entre un état passant et un état bloqué, l'interrupteur 44 comportant une électrode de commande 46, une première électrode de conduction 48 et une deuxième électrode de conduction 50.

Chaque bras 26 comprend en outre une inductance 52 connectée entre une même électrode parmi les deux électrodes de conduction 48, 50 et la borne de conduction commune 30, 32 correspondante.

En complément, chaque bras 26 comprend une résistance 54 connectée entre l'électrode de commande 46 et la borne de commande commune 28.

Le bras additionnel 27 comporte une résistance 56 et un condensateur 58 connectés en série.

La borne de commande commune 28 est reliée, par exemple, par l'intermédiaire de la résistance 54, à l'électrode de commande 46 de l'interrupteur de chacun des bras 26 connectés en parallèle.

La première borne de conduction commune 30 est reliée à la première électrode de conduction 48 de l'interrupteur de chacun des bras 26 connectés en parallèle.

La deuxième borne de conduction commune 32 est reliée par l'intermédiaire de l'inductance 52 à la deuxième électrode de conduction 50 de l'interrupteur de chacun des bras 26 connectés en parallèle.

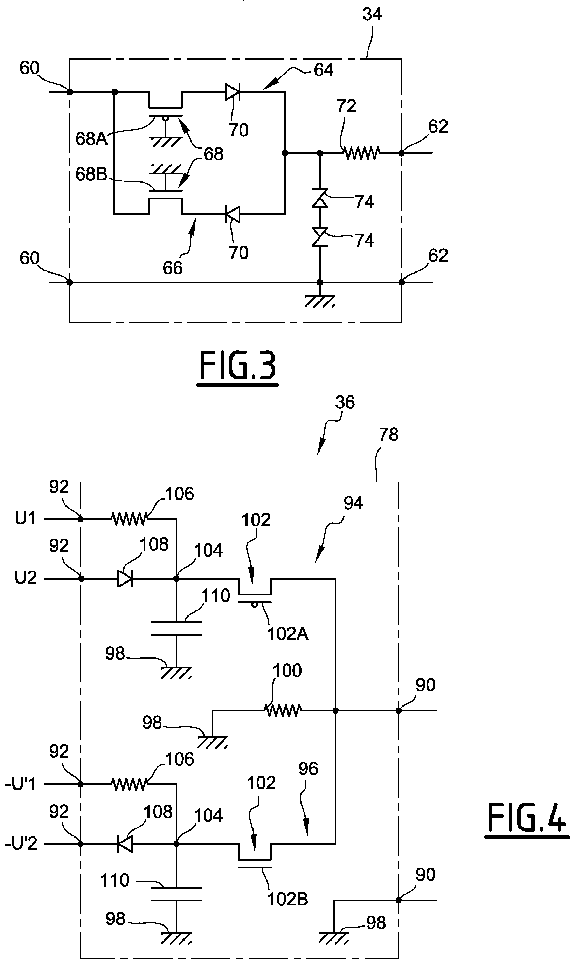

Chaque cellule de commande 34, visible sur la figure 3, comporte deux bornes d'entrée 60 connectées aux moyens d'isolation 40 et deux bornes de sortie 62 respectivement connectées à la borne de commande commune 28 et à la deuxième borne de conduction commune 32.

Chaque cellule de commande 34 comprend une première branche 64 et une deuxième branche 66 connectées en parallèle, chaque branche 64, 66 comportant un transistor 68 et une diode 70 connectés en série.

Chaque cellule de commande 34 comprend également une résistance 72 connectée entre les branches 64, 66 et la borne de sortie 62 qui est destinée à être connectée à la borne de commande commune 28. Chaque cellule de commande 34 comprend deux diodes Zener 74 connectées en série et tête-bêche entre la borne de la résistance 72 qui n'est pas connectée à la borne de sortie 62 et l'autre borne de sortie 62.

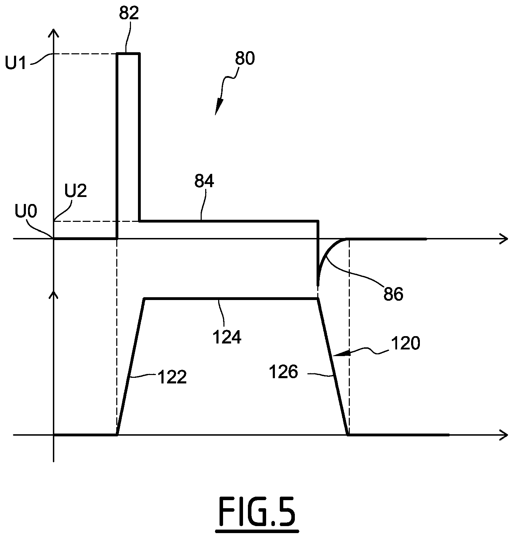

L'organe de pilotage et d'alimentation 36 comprend des moyens 78, visibles sur la figure 4, de génération d'une impulsion 80, visible sur la figure 5, l'impulsion 80 comportant un premier 82 et un deuxième 84 intervalles de commande distincts et un intervalle de transition 86, l'impulsion 80 présentant pendant le deuxième intervalle de commande 84 une valeur U2 sensiblement constante et distincte d'une valeur de référence U0 correspondant à l'absence de commande, la valeur de l'impulsion étant distincte d'un intervalle de commande à l'autre. L'impulsion 80 présente pendant le premier intervalle de commande 82 une valeur U1 strictement supérieure à la valeur U2 de l'impulsion pendant le deuxième intervalle de commande 84.

L'organe de pilotage et d'alimentation 36 est propre à piloter la pluralité de cellules de commande 34 des organes de commutation 16 du groupe 42.

La liaison de transmission 38 est une liaison filaire.

Les moyens d'isolation électrique 40 comportent, pour chaque groupe 42 d'organes de commutation, une pluralité d'enroulements secondaires 87, une pluralité de circuits magnétiques 88 et un unique enroulement primaire 89, chaque enroulement secondaire 87 étant électriquement connecté en entrée d'une cellule de commande 34 respective et enroulé autour d'un circuit magnétique 88 respectif. L'unique enroulement primaire 89 est enroulé autour de chacun des circuits 88 et électriquement connecté en sortie de l'unique organe de pilotage et d'alimentation 36.

L'interrupteur électronique 44 comporte au moins un transistor parmi le groupe consistant en : un transistor à effet de champ, un transistor IGBT (de l'anglais Insulated Gâte Bipolar Transistor) et un transistor IEGT (de l'anglais Injection Enhanced Gâte Transistor). Dans l'exemple de réalisation de la figure 2, chaque interrupteur électronique 44 est constitué d'un transistor IGBT.

Le ou chaque transistor de l'interrupteur 44 est, par exemple, propre à permettre la circulation d'un courant présentant une tension égale à 1,2 kV ou à 600 V, et une intensité égale à 30 ou 40 A.

Les interrupteurs d'un même organe de commutation 16 comportent des transistors de même type, à savoir des transistors à effet de champ, des transistors IGBT, ou encore des transistors IEGT. Les transistors d'un même organe de commutation 16, bien que de même type, sont susceptibles de présenter des caractéristiques électriques sensiblement différentes d'un transistor à l'autre.

L'électrode de commande 46 est également appelée électrode de grille lorsque l'interrupteur 44 comporte un transistor à effet de champ, un transistor IGBT ou un transistor IEGT.

La première électrode de conduction 48, respectivement la deuxième électrode de conduction 50, sont également appelées électrode de collecteur, respectivement électrode d'émetteur, lorsque l'interrupteur 44 comporte un transistor IGBT ou un transistor IEGT.

En variante, la première électrode de conduction 48, respectivement la deuxième électrode de conduction 50, sont également appelées électrode de drain, respectivement électrode de source, lorsque l'interrupteur 44 comporte un transistor à effet de champ.

Dans l'exemple de réalisation de la figure 2, ladite électrode parmi les deux électrodes de conduction 48, 50 qui est connectée à l'inductance 52 est la deuxième électrode de conduction 50. Autrement dit, ladite électrode parmi les deux électrodes de conduction qui est connectée à l'inductance 52 est l'électrode d'émetteur lorsque le transistor est un transistor IGBT ou un transistor IEGT. En variante, ladite électrode parmi les deux électrodes de conduction qui est connectée à l'inductance 52 est l'électrode de source lorsque le transistor est un transistor à effet de champ.

L'inductance 52 présente une valeur L supérieure à 10nH et est sensiblement identique pour chacun des bras 26 connectés en parallèle. L'inductance 52 présente, par exemple, une valeur L comprise entre 10nH et 100nH.

La résistance 54 est un composant passif dédié, et présente une valeur de l'ordre de quelques ohms.

La résistance 56 du bras additionnel 27 est une résistance d'amortissement des tensions parasites susceptibles d'apparaître à haute fréquence, par exemple pour des fréquences supérieures à 1 MHz. La résistance 56 présente une impédance de l'ordre de quelques ohms.

Le condensateur 58 est propre à absorber une majeure partie du courant et à limiter la dérivée de la tension par rapport au temps. Le condensateur 58 présente une capacité de valeur, par exemple comprise entre P et 10xP nF, de préférence égale à 5xP nF, où P représente le nombre de bras 26 connectés en parallèle.

Chaque condensateur 58 est propre à se charger lorsque les interrupteurs 44 de chaque organe de commutation sont à l'état bloqué, et à se décharger lorsque les interrupteurs 44 sont à l'état passant.

Le transistor 68 de la deuxième branche 66, également noté 68B, est complémentaire de celui de la première branche 64, également noté 68A. La diode 70 de la deuxième branche 66 est connectée en sens inverse par rapport à celle de la première branche 64.

Le transistor 68A de la première branche est un transistor MOSFET de type P, et le transistor 68B de la deuxième branche est un transistor MOSFET de type N. En variante, le transistor 68A de la première branche est un transistor bipolaire de type NPN, et le transistor 68B de la deuxième branche est un transistor bipolaire de type PNP.

Les moyens de génération 78, visibles sur la figure 4, comportent deux bornes de sortie 90 connectées aux deux extrémités de la liaison de transmission 38 pour la délivrance de l'impulsion 80, et des bornes d'entrée 92 reliées à des potentiels de valeurs prédéterminées.

Les moyens de génération 78 comportent une première branche 94 et une deuxième branche 96 connectées à une même borne de sortie 90, l'autre borne de sortie 90 étant reliée à la masse électrique 98. Les moyens de génération 78 comprennent également une résistance 100 connectée entre la borne de sortie reliée aux première et deuxième branches 94, 96 et la masse électrique 98.

L'impulsion 80, visible sur la figure 5, générée par les moyens de génération 78 comporte le premier intervalle de commande 82, le deuxième intervalle de commande 84 et l'intervalle de transition 86. La valeur U1 de l'impulsion durant le premier intervalle 82 est au moins deux fois supérieure à celle U2 durant le deuxième intervalle 84.

Dans l'exemple de réalisation de la figure 5, l'impulsion 80 est une impulsion en tension et le courant circulant dans la liaison filaire de transmission 38 correspondant à cette impulsion 80 est représenté par la courbe 120 visible sur la figure 5. Le courant dans la liaison filaire de transmission 38 comporte ainsi un front montant 122 correspondant au premier intervalle de commande 82, un plateau 124 où le courant présente une valeur sensiblement constante et correspondant au deuxième intervalle de commande 84. Le courant dans la liaison filaire 38 présente enfin un front descendant 126 correspondant à l'intervalle de transition 86 de l'impulsion.

La valeur U2 de l'impulsion 80 durant le deuxième intervalle de commande 84 vérifie l'équation suivante :

$$U2 = (N \times Uc) / M,$$

où N représente le nombre d'organes de commutation 16 du groupe 42 correspondant, N étant un nombre entier supérieur ou égal à 2,

Uc est la tension en entrée de la cellule de commande 34 correspondante, et

M représente le nombre de spires de l'enroulement secondaire 87 correspondant.

La durée du premier intervalle 82 est comprise entre 50 ns et 200 ns, de préférence sensiblement égale à 100 ns. La durée du deuxième intervalle 84 est comprise entre 0,2 µs et 3 µs, de préférence sensiblement égale à 1 µs.

L'intervalle de transition 86 débute avec l'ouverture de la branche 94, le courant imposé par les enroulements secondaires 87 circulant alors dans la résistance 100 connectée entre la borne de sortie 90 et la masse électrique 98. Durant l'intervalle de transition 86, la tension de l'impulsion 80 chute jusqu'à un minimum de tension de valeur supérieure ou égale à une valeur -U'1, puis s'annule progressivement.

Le circuit magnétique 88 est, par exemple, en forme de tore.

Dans l'exemple de réalisation de la figure 2, l'unique enroulement primaire 89 comporte une seule spire passant au travers de chacun des anneaux 88 correspondants. Autrement dit, la liaison filaire de transmission 38 forme l'unique enroulement primaire 89.

Chaque branche 94, respectivement 96, comporte un transistor 102 connecté entre un point de référence 104 et la borne de sortie 90 correspondante, une résistance 106 connectée entre le point de référence 104 et une borne d'entrée 92 reliée à un premier potentiel de valeur U1, respectivement -U'1, une diode 108 connectée entre le point de référence 104 et une autre borne d'entrée 92 reliée à un deuxième potentiel de valeur U2, respectivement -U'2, et un condensateur 110 connecté entre le point de référence 104 et la masse électrique 98.

La valeur U1, -U'1 du premier potentiel est supérieure en valeur absolue à celle U2, -U'2 du deuxième potentiel. Les valeurs U1, U2 correspondant à la première branche sont positives, et celles correspondant à la deuxième branche 96 sont négatives. Autrement, la valeur U1 est supérieure à U2, elle-même supérieure à -U'2, elle-même supérieure à -U'1.

Le transistor 102 de la première branche 94, également noté 102A, est complémentaire de celui de la deuxième branche 96, également noté 102B. La diode 108 de la deuxième branche 96 est connectée en sens inverse par rapport à celle de la première branche 94.

Le transistor 102A de la première branche est un transistor MOSFET de type P, et le transistor 102B de la deuxième branche est un transistor MOSFET de type N. En variante, le transistor 102A de la première branche est un transistor bipolaire de type NPN, et le transistor 102B de la deuxième branche est un transistor bipolaire de type PNP.

Lors du fonctionnement du système de conversion, l'impulsion de commande 80 est générée par l'organe de pilotage et d'alimentation 36 sur la liaison filaire de transmission 38 qui présente une inductance qui s'ajoute à l'inductance parasite du tore 88. Autrement dit, l'enroulement primaire 89 formé par la liaison filaire 38 et comportant une seule spire présente une inductance de fuite élevée susceptible d'engendrer une augmentation du temps d'établissement du courant.

L'impulsion 80 générée par l'organe de pilotage et d'alimentation 36 comporte le premier intervalle de commande 82 de tension élevée pour permettre l'établissement du courant sur une courte durée (front montant 122), le deuxième intervalle 84 de durée relativement longue correspondant au maintien du courant (plateau 124) et enfin l'intervalle parasite 86 correspondant au retour du courant à une valeur nulle (front descendant 126).

Les deux premiers intervalles 82, 84 successifs permettent de commander l'organe de commutation 16, par exemple en mode passant dans l'exemple de réalisation de la figure 5.

En complément, l'impulsion 80 comprend également trois intervalles, non représentés, avec des tensions de signe opposé à celles préalablement décrites pour la commande de l'organe de commutation 16 en mode bloqué. Autrement dit, l'impulsion 80 pour la commande de l'organe de commutation 16 en mode bloqué présente la valeur - U'1 pendant le premier intervalle de commande, puis la valeur -U'2 pendant le deuxième intervalle de commande. Durant l'intervalle de transition, la tension de l'impulsion 80 augmente jusqu'à un maximum de tension de valeur inférieure ou égale à U1, puis s'annule progressivement.

Lorsque l'impulsion 80 présente les intervalles positifs de commande 82, 84, le transistor 68A de type P de la première branche de la cellule de commande 34 est conducteur, alors que le transistor 68B de type N de la deuxième branche de la cellule de commande est bloqué. Le courant passe alors à travers la première branche 64 de la cellule de commande jusqu'aux électrodes de commande 46 des interrupteurs 44, ce qui commande les interrupteurs 44 en mode passant. A la fin de l'impulsion 80, le transistor 68B de type N reste bloqué, ce qui permet de maintenir l'électrode de commande 46 dans un état chargé.

Le fonctionnement est inversé pour la commande de l'organe de commutation 16 dans son mode bloqué. Plus précisément, les intervalles de commande, non représentés, de l'impulsion 80 présentent des tensions successives négatives, et le transistor 68B de type P de la cellule de commande 34 est conducteur, alors que le transistor 68A de type P de la même cellule de commande est à l'état bloqué. Le courant circule depuis la borne de sortie 62 de la cellule de commande vers la borne d'entrée 60 correspondante. Autrement dit, l'électrode de commande 46 des interrupteurs 44 ne reçoit plus de courant de commande, et les interrupteurs 44 sont alors en mode bloqué.

L'homme du métier comprendra également que plusieurs impulsions 80 positives peuvent être générées successivement, afin de maintenir le signal de commande sur les électrodes de commande 46 des interrupteurs pendant une durée relativement longue.

La connexion en série des organes de commutation 16 pour former un groupe d'organes 42 permet d'obtenir une tension de sortie de valeur plus importante, tout en limitant les déséquilibres de tension entre les organes de commutation connectés en série, la dérivée par rapport au temps de la tension aux bornes de chaque organe de commutation 16 étant contrôlée via la valeur de la capacité de chaque condensateur 58.

On conçoit ainsi que le système de conversion 10 selon l'invention permet d'accélérer la commutation des organes de commutation, afin d'augmenter la fréquence de commutation desdits organes de commutation, et également de réduire les éventuels décalages temporels entre les commutations des organes de commutation.

**Revendications**

1. Système (10) de conversion d'une première tension électrique en une deuxième tension électrique, du type comprenant :

   - au moins deux bornes d'entrée (12) et deux bornes de sortie (14),
   - des organes de commutation (16) disposés entre les bornes d'entrée (12) et les bornes de sortie (14) et propres à convertir la première tension en la deuxième tension, et
   - un dispositif (24) de commande des organes de commutation (16), le dispositif de commande (24) comportant une cellule (34) de commande d'un organe de commutation (16) respectif et un organe (36) de pilotage et d'alimentation de la cellule de commande (34), l'organe de pilotage et d'alimentation étant relié à la cellule de commande par une liaison (38) de transmission simultanée d'un signal de commande et d'une énergie électrique,

   **caractérisé en ce que** :

   - l'organe de pilotage et d'alimentation (36) comprend des moyens (78) de génération d'une impulsion (80) comportant un premier intervalle de commande (82) pour permettre l'établissement du courant circulant dans la liaison entre l'organe de pilotage et les cellules de commande, un deuxième intervalle de commande (84) correspondant au maintien du courant, et un intervalle de transition (86) correspondant au retour du courant à une valeur nulle, l'impulsion (80) présentant pendant le deuxième intervalle de commande (84) une valeur (U2) sensiblement constante et distincte d'une valeur de référence (U0) correspondant à l'absence de commande, la valeur de l'impulsion (U1, U2) étant distincte d'un intervalle de commande à l'autre et l'impulsion (80) présentant pendant le premier intervalle de commande (82) une valeur (U1) strictement supérieure à celle (U2) pendant le deuxième intervalle de commande (84) ;

   le système (10) comprend au moins un groupe (42) d'organes de commutation (16) connectés en série, le ou chaque groupe (42) étant connecté entre une borne de sortie (14) et une borne d'entrée (12) correspondantes, une cellule de commande (34) respective étant associée à chaque organe de commutation (16), dans lequel l'organe de pilotage et d'alimentation (36) est unique pour les cellules de commande des organes de commutation (16) d'un même groupe (42), et propre à piloter la pluralité de cellules de commande des organes de commutation (16) du groupe ; et

   le dispositif de commande (24) comporte en outre des moyens d'isolation électrique (40) agencés entre chaque cellule de commande (34) et l'organe de pilotage et d'alimentation (36), dans lequel les moyens d'isolation électrique (40) comportent, pour chaque groupe (42) d'organes de commutation (16), une pluralité d'enroulements secondaires (87), une pluralité de circuits magnétiques (88) et un unique enroulement primaire (89), chaque enroulement secondaire (87) étant électriquement connecté en entrée d'une cellule de commande (34) respective et enroulé autour d'un circuit magnétique (88) respectif, l'unique enroulement primaire (89) étant enroulé autour de chacun des circuits (88) et électriquement connecté en sortie de l'unique organe de pilotage et d'alimentation (36).

2. Système (10) selon la revendication 1, dans lequel les intervalles (82, 84, 86) d'une même impulsion sont successifs l'un de l'autre.

3. Système (10) selon la revendication 1 ou 2, dans lequel l'unique enroulement primaire (89) comporte une seule spire passant au travers de chacun des circuits magnétiques correspondants.

4. Système (10) selon l'une quelconque des revendications précédentes, dans lequel la valeur (U1) de l'impulsion durant le premier intervalle (82) est au moins deux fois supérieure à celle (U2) durant le deuxième intervalle (84).

5. Système (10) selon l'une quelconque des revendications précédentes, dans lequel la durée du premier intervalle de commande (82) est comprise entre 50 ns et 200 ns, de préférence égale à 100 ns.

6. Système (10) selon les revendications 1, 4 et 5 prises ensemble, dans lequel la valeur U2 de l'impulsion (80) durant le deuxième intervalle (84) vérifie l'équation suivante :

$$U2 = (N \times Uc) / M,$$

où N représente le nombre d'organes de commutation du groupe (42) correspondant, N étant un nombre entier supérieur ou égal à 2, Uc est la tension en entrée de la cellule de commande (34) correspondante, et M représente le nombre de spires de l'enroulement secondaire (87) correspondant.

7.  Système (10) selon l'une quelconque des revendications précédentes, dans lequel chaque cellule de commande (34) comprend une première branche (64) et une deuxième branche (66) connectées en parallèle, chaque branche (64, 66) comportant un transistor (68, 68A, 68B) et une diode (70) connectés en série, le transistor (68B) de la deuxième branche (66) étant complémentaire de celui (68A) de la première branche (64), et la diode (70) de la deuxième branche (66) étant connectée en sens inverse par rapport à celle de la première branche (64).

8.  Système (10) selon l'une quelconque des revendications précédentes, dans lequel les moyens de génération d'une impulsion (78) comportent une borne de sortie (90) pour la délivrance de l'impulsion, et une première branche (94) et une deuxième branche (96) connectées à la borne de sortie (90), chaque branche (94, 96) comportant un transistor (102, 102A, 102B) connecté entre un point de référence (104) et la borne de sortie (90), une résistance (106) connectée entre le point de référence (104) et un premier potentiel (U1, -U'1), une diode (108) connectée entre le point de référence (104) et un deuxième potentiel (U2, -U'2), et un condensateur (110) connecté entre le point de référence (104) et une masse électrique (98), le transistor (102B) de la deuxième branche (96) étant complémentaire de celui de la première branche (94), et la diode (108) de la deuxième branche (96) étant connectée en sens inverse par rapport à celle de la première branche (94).

**Patentansprüche**

1.  System (10) zum Umwandlung einer ersten elektrischen Spannung in eine zweite elektrische Spannung, des Typs aufweisend:

    - wenigstens zwei Eingangsanschlüsse (12) und zwei Ausgangsanschlüsse (14),
    - Kommutierungselemente (16), die zwischen den Eingangsanschlüssen (12) und den Ausgangsanschlüssen (14) angeordnet sind und eingerichtet sind, um die erste Spannung in die zweite Spannung zu wandeln, und
    - eine Steuereinrichtung (24) der Kommutierungselemente (16), wobei die Steuereinrichtung (24) eine Steuerzelle (34) eines jeweiligen Kommutierungselements (16) und ein Steuer- und Versorgungselement (36) der Steuerzelle (34) aufweist, wobei das Steuer- und Versorgungselement mit der Steuerzelle über eine Verbindung (38) zur simultanen Übertragung eines Steuersignals und elektrischer Energie in Verbindung steht,

    **dadurch gekennzeichnet, dass**:

    - das Steuer- und Versorgungselement (36) Mittel (78) zur Erzeugung eines Impulses (80) aufweist, aufweisend ein erstes Steuerintervall (82), um die Ausbildung eines zirkulierenden Stromes in der Verbindung zwischen dem Steuerorgan und den Steuerzellen zu ermöglichen, ein zweites Steuerintervall (84), das einem Aufrechterhalten des Stromes entspricht und ein Übergangsintervall (86), das dem Zurückkehren des Stromes auf einen Wert null entspricht, wobei der Impuls (80) während des zweiten Steuerintervalls (84) einen Wert (U2) bereitstellt, der im Wesentlichen konstant ist und verschieden ist von einem Referenzwert (U0), der der Abwesenheit des Steuerbefehls entspricht, wobei der Wert des Impulses (U1, U2) verschieden ist von einem Steuerintervall zum anderen und der Impuls (80) während des ersten Steuerintervalls (82) einen Wert (U1) bereitstellt, der streng oberhalb desjenigen (U2) während des zweiten Steuerintervalls (84) ist;

    wobei das System (10) wenigstens eine Gruppe (42) von Kommutierungselementen (16) aufweist, die in Reihe geschaltet sind, wobei die oder jede Gruppe (42) zwischen einem Ausgangsanschluss (14) und einem korrespondierenden Eingangsanschluss (12) geschaltet ist oder sind, wobei eine jeweilige Steuerzelle (34) mit jedem Kommutierungselement (16) verknüpft ist, bei dem das Steuer- und Versorgungselement (36) einmalig für die Steuerzellen der Kommutierungselemente (16) derselben Gruppe (42) ist und dazu eingerichtet ist, die Mehrzahl der Steuerzellen der Kommutierungselemente (16) der Gruppe zu steuern; und wobei die Steuereinrichtung (24) außerdem Mittel zur elektrischen Isolation (40) aufweist, die zwischen jeder Steuerzelle (34) und dem Steuer- und Versorgungselement (36) angeordnet sind, in der die Mittel zur elektrischen Isolation (40) für jede Gruppe (42) der Kommutierungselemente (16) eine Mehrzahl von Sekundärwicklungen (87), eine Mehrzahl von magnetischen Kreisen (88) und eine einzige Primärwicklung (89) aufweisen, wobei jede Sekundärwicklung (87) elektrisch mit einem Eingang einer jeweiligen Steuerzelle (34) verbunden und um einen jeweiligen Magnetkreis (88) gewickelt ist, wobei die einzige Primärwicklung (89) um jeden der Kreise (88) gewickelt und elektrisch mit dem Ausgang des einzigen Steuer- und Versorgungselements (36) verbunden ist.

2. System (10) nach Anspruch 1, bei dem die Intervalle (82, 84, 86) desselben Impulses eines nach dem anderen aufeinanderfolgend sind.

3. System (10) nach Anspruch 1 oder 2, bei dem die einzige Primärwicklung (89) eine einzige Windung aufweist, die über jeden der entsprechenden Magnetkreise verläuft.

4. System (10) nach irgendeinem der vorhergehenden Ansprüche, bei dem der Wert (U1) des Impulses während des ersten Intervalls (82) mindestens zweimal größer ist als derjenige (U2) während des zweiten Intervalls (84).

5. System (10) nach irgendeinem der vorhergehenden Ansprüche, bei dem die Dauer des ersten Steuerintervalls (82) zwischen 50 ns und 200 ns, vorzugsweise gleich 100 ns beträgt.

6. System (10) nach den Ansprüchen 1, 4 und 5 gemeinsam, bei dem der Wert U2 des Impulses (80) während des zweiten Intervalls (84) die nachfolgende Gleichung erfüllt:

$$U2 = (N \times Uc)/M,$$

wobei N die Anzahl der Kommutierungselemente der entsprechenden Gruppe (42) darstellt, wobei N eine ganze Zahl größer oder gleich 2 ist, Uc die Spannung am Eingang der jeweiligen Steuerzelle (34) ist, und M die Anzahl der Windungen der entsprechenden Sekundärwicklung (87) ist.

7. System (10) nach irgendeinem der vorhergehenden Ansprüche, bei dem jede Steuerzelle (34) einen ersten Zweig (64) und einen zweiten Zweig (66) aufweist, die parallel geschaltet sind, wobei jeder Zweig (64, 66) einen Transistor (68, 68A, 68B) und eine Diode (70) aufweist, die in Reihe geschaltet sind, wobei der Transistor (68B) des zweiten Zweiges (66) komplementär zu demjenigen (68A) des ersten Zweiges (66) ist, und die Diode (70) des zweiten Zweiges (66) in einem inversen Sinn mit Bezug zu derjenigen des ersten Zweiges (64) geschaltet ist.

8. System (10) nach irgendeinem der vorhergehenden Ansprüche, bei dem die Mittel zur Erzeugung eines Impulses (78) einen Ausgangsanschluss (90) zum Abgeben des Impulses und einen ersten Zweig (94) und einen zweiten Zweig (96) aufweisen, die mit dem Ausgangsanschluss (90) verbunden sind, wobei jeder Zweig (94, 96) einen Transistor (102, 102A, 102B) aufweist, der zwischen einem Referenzpunkt (104) und dem Ausgangsanschluss (90) geschaltet ist, wobei ein Widerstand (106) zwischen den Referenzpunkt (104) und ein erstes Potential (U1, -U'1) geschaltet ist, wobei eine Diode (108) zwischen den Referenzpunkt (104) und ein zweites Potential (U2, -U'2) geschaltet ist und ein Kondensator (110) zwischen den Referenzpunkt (104) und eine elektrische Masse (98) geschaltet ist, wobei der Transistor (102B) des zweiten Zweiges (96) komplementär zu demjenigen des ersten Zweiges (94) ist und die Diode (108) des zweiten Zweiges (96) in inversem Sinn mit Bezug zu derjenigen des ersten Zweiges (94) geschaltet ist.

## Claims

1. System (10) for converting a first electric voltage into a second electric voltage, of the type comprising:

   - at least two input terminals (12) and two output terminals (14),
   - switching members (16) arranged between the input terminals (12) and the output terminals (14) and able to convert the first voltage into the second voltage, and
   - a device (24) for controlling the switching members (16), said control device (24) comprising a cell (34) for controlling a respective switching member (16) and a member (36) for managing and supplying the control cell (34), said management and supply member being connected to the control cell via a link (38) allowing the simultaneous transmission of a control signal and electrical energy,

   **characterised in that**:

   - the management and supply member (36) comprises means (78) for generating a pulse (80) comprising at least one first control interval (82) for allowing establishment of the current circulating in the link between the management member and the control cells, a second control interval (84) corresponding to maintaining the current, and a transition interval (86) corresponding to return of the current to a value of zero, the pulse (80) during the second control interval (84) having a substantially constant value (U2) different from a reference value (U0) corresponding to the absence of control, the value of the pulse (U1, U2) being different from one control interval to another, and the pulse (80) during the first control interval (82) having a value (U1) which is strictly greater than that (U2) during the second control interval (84);

- the system (10) comprises at least one group (42) of switching members (16) connected in series, the or each group (42) being connected between a corresponding output terminal (14) and an input terminal (12), a respective control cell (34) being associated with each switching member (16), wherein a single management and supply member (36) is provided for the control cells of the switching members (16) of a same group (42) and is able to manage the plurality of control cells of the switching members (16) of the group; and

- the control device (24) also comprises electrical isolation means (40) arranged between each control cell (34) and the management and supply member (36), wherein the electrical isolation means (40) comprise, for each group (42) of switching members (16), a plurality of secondary windings (87), a plurality of magnetic circuits (88) and a single primary winding (89), each secondary winding (87) being electrically connected to the input of a respective control cell (34) and wound around a respective magnetic circuit (88), the single primary winding (89) being wound around each of the circuits (88) and electrically connected to the output from the single management and supply member (36).

**2.** System (10) according to claim 1, wherein the intervals (82, 84, 86) of a same pulse are successive to each other.

**3.** System (10) according to claim 1 or 2, wherein the single primary winding (89) comprises a single turn passing through each of the corresponding magnetic circuits.

**4.** System (10) according to any of the preceding claims, wherein the value (U1) of the pulse during the first interval (82) is at least two times greater than that (U2) during the second interval (84).

**5.** System (10) according to any of the preceding claims, wherein the duration of the first control interval (82) is between 50 ns and 200 ns, preferably equal to 100 ns.

**6.** System (10) according to claims 1, 4 and 5 taken together, wherein the value U2 of the pulse (80) during the second interval (84) verifies the following equation:

$$U2 = (N \times Uc) / M$$

where N represents the number of switching members of the corresponding group (42), N being an integer greater than or equal to 2,
Uc is the voltage at the input to the corresponding control cell (34), and
M represents the number of turns of the corresponding secondary winding (87).

**7.** System (10) according to any of the preceding claims, wherein each control cell (34) comprises a first branch (64) and a second branch (66) connected in parallel, each branch (64, 66) comprising a transistor (68, 68A, 68B) and a diode (70) connected in series, the transistor (68B) of the second branch (66) being complementary to that (68A) of the first branch (64), and the diode (70) of the second branch (66) being connected in the opposite direction to that of the first branch (64).

**8.** System (10) according to any of the preceding claims, wherein the means for generating a pulse (78) comprise an output terminal (90) for supplying the pulse, and a first branch (94) and a second branch (96) connected to the output terminal (90), each branch (94, 96) comprising a transistor (102, 102A, 102B) connected between a reference point (104) and the output terminal (90), a resistor (106) connected between the reference point (104) and a first potential (U1, -U'1), a diode (108) connected between the reference point (104) and a second potential (U2, -U'2), and a capacitor (110) connected between the reference point (104) and an electrical ground (98), the transistor (102B) of the second branch (96) being complementary to that of the first branch (94), and the diode (108) of the second branch (96) being connected in the opposite direction to that of the first branch (94).

## FIG.1

FIG.2

## FIG.3

## FIG.4

FIG.5

**RÉFÉRENCES CITÉES DANS LA DESCRIPTION**

**Documents brevets cités dans la description**

- US 20100302820 A1